# EUROPEAN PATENT SPECIFICATION

(11) **EP 2 921 932 B1**
(45) Date of publication and mention of the grant of the patent: **10.04.2019**
(21) Application number: 15155098.5
(22) Date of filing: 13.02.2015
(51) Int. Cl.: G06F 1/20

(54) **Heat dissipating system using fans**
Wärmeableitungssystem mit Lüftern
Système de dissipation de chaleur utilisant des ventilateurs

(30) Priority: 17.03.2014 CN 201410097749
(43) Date of publication of application: 23.09.2015
(73) Proprietor: Maintek Computer (Suzhou) Co., Ltd., SND. JiangSu (CN); Pegatron Corporation, Taipei City 112 (TW)
(72) Inventor: Gong, Li- Qun, SND. JiangSu (CN); Chang, Chih-Hao, Taipei City 112 (CN)
(74) Representative: Haseltine Lake LLP

(56) References cited:
- US-A1- 2009 219 673
- US-A1- 2012 182 687
- US-A1- 2013 081 779
- US-A1- 2014 041 827

## Description

### BACKGROUND

### Technology Field

The disclosure relates to a heat dissipating system using fans and, in particular, to a heat dissipating system having at least two fans.

### Related Art

Along with the rapid development of electronic technology, various electronic devices have been used with growing popularity in our daily lives. The electronic components in the electronic device (such as the central processing unit or other processor) generate heat during operation. To ensure that these electronic components function normally, a fan is commonly provided in the electronic device, and an air inlet and an air outlet are also formed at the housing of the electronic device. Through the airflow generated by the fan in the housing, the heat generated by the electronic component can be removed from the electronic device.

Most electronic devices have only one fan to dissipate heat. When the computation amount of the processor becomes larger, it is difficult to use one fan to meet the heat dissipation requirement of the system. Presently, some electronic devices have two fans and determine whether to use a single fan or two fans based on the temperature. However, the design of these electronic devices with two fans does not consider the operation habit of a user. For example, the heated airflow from the electronic device may blow toward the user to reduce the comfort of the user during operation.

US 2012/182687 describes a method for cooling an electronic device having first and second flow paths for transmitting a coolant. Other heat dissipating systems for an electronic device are disclosed by US 2009/219673, US 2013/081779 and US 2014/041827.

### SUMMARY

The invention provides a heat dissipating system having two fans and capable of adjusting which fan to be activated according to user's habit and the orientation of the electronic device.

A heat dissipating system using fans according to the invention is for an electronic device. The electronic device includes a housing, and the housing includes a first side surface and a second side surface opposite to each other. The first side surface and the second side surface have a first air outlet and a second air outlet, respectively. The heat dissipating system using fans includes a first fan, a second fan, an orientation sensor, a temperature sensor, a user interface circuit module comprising a memory and a processor. The first fan is disposed in the housing at a position corresponding to the position of the first air outlet. The second fan is disposed in the housing at a position corresponding to the position of the second air outlet. The orientation sensor is disposed in the housing for sensing whether the electronic device is under a vertical state or a horizontal state and generating a corresponding orientation signal. The temperature sensor is disposed in the housing for sensing the temperature of the electronic device and generating a temperature signal. The user interface circuit module is disposed in the housing for receiving handedness information input by a user and store it in its memory. The processor is disposed in the housing and is electrically connected with the first fan, the second fan, the orientation sensor, the temperature sensor and the user interface circuit module. When the temperature signal is greater than or equal to a predetermined value, the processor activates the first fan and the second fan; when the temperature signal is less than the predetermined value, the processor selectively activates one of the first fan and the second fan according to the handedness information transmitted by the user interface circuit module and the orientation signal.

In one embodiment of the invention, the housing may further include a front surface connecting the first side surface and the second side surface. The electronic device may include a touch panel disposed at the front surface. The front surface may be rectangular, and the side connecting the front surface and the first side surface may be a long side. When the electronic device is under the vertical state and the temperature signal is less than the predetermined value, the processor may activate one of the first fan and the second fan according to the handedness information.

In one embodiment of the invention, when the electronic device is under the horizontal state and the temperature signal is less than the predetermined value, the processor may activate the first fan or the second fan at the top.

In one embodiment of the invention, the housing may further include a front surface connecting the first side surface and the second side surface. The electronic device may include a touch panel disposed at the front surface. The front surface may be rectangular, and the side connecting the front surface and the first side surface may be a short side. When the electronic device is under the vertical state and the temperature signal is less than the predetermined value, the processor may activate the first fan or the second fan at the top.

In one embodiment of the invention, when the electronic device is under the horizontal state and the temperature signal is less than the predetermined value, the processor may selectively activate one of the first fan and the second fan according to the handedness information.

In one embodiment of the invention, the second side surface and the first side surface may have a first air inlet and a second air inlet, respectively. The position of the second air inlet on the first side surface may correspond to the position of the second air outlet, and the position of the first air inlet on the second side surface may correspond to the position of the first air outlet.

In one embodiment of the invention, the processor may be a central processing unit of the electronic device.

In one embodiment of the invention, the heat dissipating system using fans may further include two heat pipes disposed in the housing and extending from the processor to the first air outlet and the second air outlet, respectively.

In one embodiment of the invention, the processor may store default handedness information in a built-in memory.

To sum up, the heat dissipating system using fans of the invention has a dual-fan design. When the computation amount of the electronic device does not exceed a specific amount, i.e., when the temperature of the electronic device is lower than a predetermined value, the heat dissipating system using fans can only activate a single fan to dissipate heat according to the handedness information and the orientation of the electronic device. This can solve the problem that the heated airflow blows toward the user.

The invention will become more fully understood from the detailed description and accompanying drawings, which are given for illustration only, and thus are not limitative of the present invention.

### BRIEF DESCRIPTION OF THE DRAWINGS

FIG. 1 is a schematic diagram of an electronic device having a heat dissipating system using fans according to an embodiment of the invention;
FIG. 2 is a schematic diagram of the electronic device shown in FIG. 1 under a vertical state;
FIG. 3 is a schematic diagram of a heat dissipating system using fans according to another embodiment of the invention; and
FIG. 4 is a schematic diagram of the electronic device shown in FIG. 3 under a vertical state.

### DETAILED DESCRIPTION OF THE EMBODIMENT

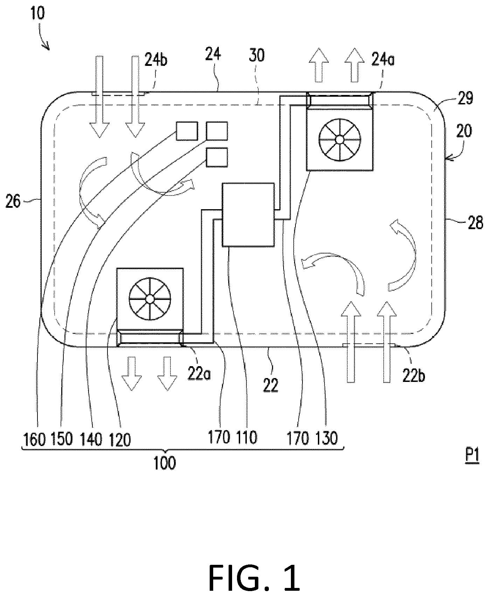

FIG. 1 is a schematic diagram showing an electronic device having a heat dissipating system using fans according to an embodiment of the invention. Referring to FIG. 1, a heat dissipating system using fans 100 is for an electronic device 10. In the present embodiment, the electronic device 10 may be a tablet computer for example. However, in other embodiments, the electronic device may be other device that can be placed vertically or horizontally.

The electronic device 10 includes a housing 20 and a touch panel 30. The housing 20 includes a first side surface 22 and a second side surface 24 opposite to each other, a third side surface 26 and a fourth side surface 28 opposite to each other, and a front surface 29 connected with the first side surface 22, the second side surface 24, the third side surface 26, and the fourth side surface 28. The touch panel 30 is disposed at the front surface 29 of the housing 20 (to show the relationship between the heat dissipating system using fans 100 and the housing 20 clearly, the touch panel 30 is shown in dotted lines). If the touch panel 30 of the electronic device 10 faces the user, the first side surface 22, the second side surface 24, the third side surface 26, or the fourth side surface 28 is one of the top, bottom, left or right side surface of the electronic device 10.

In the present embodiment, the front surface 29 is rectangular. Both the side connecting the front surface 29 and the first side surface 22 and the side connecting the front surface 29 and the second side surface 24 are long sides, and both the side connecting the front surface 29 and the third side surface 26 and the side connecting the front surface 29 and the fourth side surface 28 are short sides. The first side surface 22 has a first air outlet 22a and a second air inlet 22b. The second side surface 24 has a second air outlet 24a and a first air inlet 24b. The position of the second air inlet 22b on the first side surface 22 corresponds to the position of the second air outlet 24a, and the position of the first air inlet 24b on the second side surface 24 corresponds to the position of the first air outlet 22a. Of course, the positional relationship between the first air inlet 24b and the first air outlet 22a and the positional relationship between the second air inlet 22b and the second air outlet 24a are not limited thereby.

The heat dissipating system using fans 100 of the embodiment includes a processor 110, a first fan 120, a second fan 130, a user interface circuit module 140, an orientation sensor 150, and a temperature sensor 160. The processor 110 is disposed in the housing 20 and is electrically connected with the first fan 120, the second fan 130, the user interface circuit module 140, the orientation sensor 150, and the temperature sensor 160. The first fan 120 is disposed in the housing 20 at a position corresponding to that of the first air outlet 22a. The second fan 130 is disposed in the housing 20 at a position corresponding to that of the second air outlet 24a. The air outside the housing 20 can be brought into the housing 20 from the first air inlet 24b and the second air inlet 22b and exit from the first air outlet 22a and the second air outlet 24a through the driving of the first fan 120 and the second fan 130 to realize the air circulation inside the housing 20 of the electronic device 10.

In the present embodiment, the user interface circuit module 140 is used for receiving handedness information and transmitting the handedness information to the processor 110. The orientation sensor 150 is disposed in the housing 20 for sensing whether the electronic device 10 is under a horizontal state PI or a vertical state P2 and generating a corresponding orientation signal. In the present embodiment, the orientation sensor 150 is a gravity sensor. In other embodiments, the orientation sensor 150 may be an angle sensor. The temperature sensor 160 is disposed in the housing 20 for sensing the temperature of the electronic device 10 and generating a temperature signal.

The user interface circuit module 140 includes a memory (not shown). The handedness information input by the user is stored in the memory. The memory is electrically connected with the processor 110. During the operation of the electronic device 10, the processor 110 retrieves the handedness information stored in the memory and determines whether to activate the first fan 120 or the second fan 130 under the single-fan operation mode according to the handedness information and the orientation signal.

More specifically, when the user starts to use the electronic device 10, the handedness information (the dominant hand is the left hand or the right hand) can be input to the user interface circuit module 140 to perform an initial setup. The user interface circuit module 140 transmits the handedness information to the processor 110. Furthermore, the orientation sensor 150 senses whether the electronic device 10 is under the horizontal state PI or the vertical state P2 and generates the corresponding orientation signal. The orientation signal is also transmitted to the processor 110. Before the temperature of the electronic device 10 exceeds the predetermined value, the processor 110 would select to activate the first fan 120 or the second fan 130 based on the received handedness information and the orientation signal.

How the processor 110 selects one of fans to activate may be described below with the right hand as the dominant hand as an example. Generally speaking, when a user with the right hand as the dominant hand uses the electronic device 10, such as a tablet PC, the user grips the electronic device 10 with the left hand and inputs information on the touch panel 30 with the right hand. As shown in FIG. 1, when the user places the electronic device 10 under the horizontal state PI, the left hand of the user grips the third side surface 26 of the housing 20. Under this situation, the second side surface 24 is at the top and the first side surface 22 is at the bottom. Since the touch panel 30 would tilt toward the user slightly when the user grips the electronic device 10, if the temperature signal is less than the predetermined value, the processor 100 activates the second fan 130 at the top to let the heated air flow out from the second air outlet 24a to prevent the heated air from blowing toward the user. As a result, the situation that the heated air blows toward the user when the user operates the electronic device 10 can be prevented.

Similarly, when the left hand of the user grips the fourth side surface 28 of the housing 20, the first side surface 22 is at the top and the second side surface 24 is at the bottom. The processor 110 activates the first fan 120 at the top to let the heated air flow out from the first air outlet 22a. That is, in the present embodiment, under the situation that the first fan 120 and the second fan 130 are disposed at the long sides, when the electronic device 10 is under the horizontal state PI and the temperature signal generated by the temperature sensor 160 is less than the predetermined value, the processor 110 would activate the first fan 120 or the second fan 130 at the top.

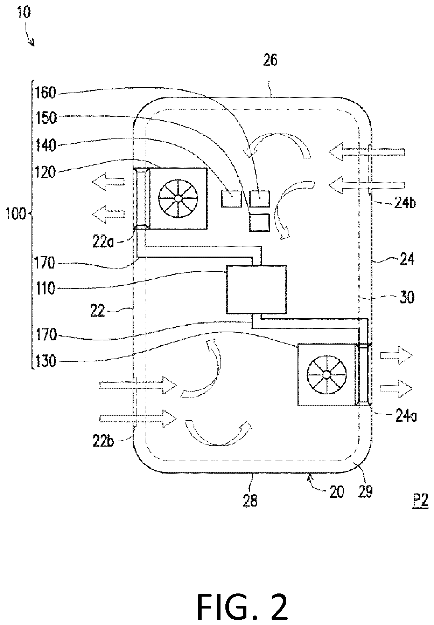

FIG. 2 is a schematic diagram showing the electronic device of FIG. 1 under the vertical state. Referring to FIG. 2, when the user places the electronic device 10 under the vertical state P2, if the user grips the first side surface 22 of the housing 20 and the temperature signal is less than the predetermined value, the processor 110 activates the second fan 130 which is close to the side of the dominant hand (that is, the right hand). As a result, the heated air would not keep blowing toward the left hand gripping the electronic device 10. Since the right hand of the user moves back and forth on the touch panel 30, the heated air from the second air outlet 24a of the second side surface 24 is less likely to affect the user.

Similarly, if the left hand of the user grips the second side surface 24 of the housing 20, the processor 110 activates the first fan 120 which is closer to the side of the dominant hand. As a result, the heated air would not keep blowing toward the left hand gripping the electronic device 10. Since the right hand of the user moves on the touch panel 30, the user would be less likely to feel the heated air flowing out from the first air outlet 22a of the first side surface 22. That is, in the present embodiment, under the situation that the first fan 120 and second fan 130 are disposed at the long sides, when the electronic device 10 is under the vertical state P2 and the temperature signal generated by the temperature sensor 160 is less than the predetermined value, the processor 110 would selectively activate one of the first fan 120 and the second fan 130 based on the handedness information.

From the above, as long as the user sets the handedness information, the processor 110 controls which fan to be activated during operation based on the orientation of the electronic device 10 and the handedness information if the temperature signal is less than the predetermined value. The problem that the user is affected by the heated airflow when gripping the electronic device 10 can be solved. As a result, the user can use the electronic device 10 more freely without considering which side surface to grip or which angle of the electronic device 10 to tilt to avoid the heated airflow.

Moreover, in another embodiment, the physical component of user interface circuit module 140 may not be disposed. The processor 110 can have a built-in memory, and the handedness information can be stored in the built-in memory of the processor 110 directly and be changed via software subsequently.

Note that in this embodiment, the built-in memory of the processor 110 can store default handedness information. The default handedness information indicates, for example, that the right hand is the dominant hand. When the processor 110 does not receive the handedness information from the user interface circuit module 140, if the temperature signal is less than the predetermined value, the processor 110 selectively activates the first fan 120 or the second fan 130 based on the default handedness information and the orientation signal.

Moreover, in the present embodiment, the processor 110 may be the central processing unit of the electronic device 10. The temperature sensor 160 can sense the temperature of the processor 110 to generate the temperature signal. However, the invention is not so limited. In other embodiments, the processor 110 may be another external processor independent from the electronic device 10, or another processor in the electronic device 10. In the present embodiment, when the temperature signal is greater than or equal to the predetermined value, the processor 110 can activate the first fan 120 and the second fan 130 simultaneously to dissipate heat more efficiently so that the heat inside the housing 20 can be dissipated as fast as possible. Of course, the predetermined value allowing the processor 110 to activate the first fan 120 and the second fan 130 simultaneously can be set by the user to fit the user's needs.

Furthermore, in the present embodiment, the heat dissipating system using fans 100 further includes two heat pipes 170 which are disposed in the housing 20 and extend from the processor 110 to the first air outlet 22a and the second air outlet 24a, respectively. Note that since in the present embodiment the processor 110 is the central processing unit of the electronic device 10, the two heat pipes 170 extend from the processor 110, respectively. In other embodiments, when the processor 110 is independent from the heat source (the central processing unit here) of the electronic device 10, the heat pipes 170 can extend from the heat sources of the electronic device 10, respectively. The heat pipes 170 are used to guide the flow path of the heated air in the housing 20, so that the airflow in the housing 20 can pass the processor 110 more concentratedly to remove heat from the electronic device 10 more effectively. In other embodiments, the positions of the first fan 120 and the second fan 130 and the number and distribution of the heat pipes 170 can be adjusted according to the internal mechanical design of the housing 20, and are not limited by the configuration shown in the drawings.

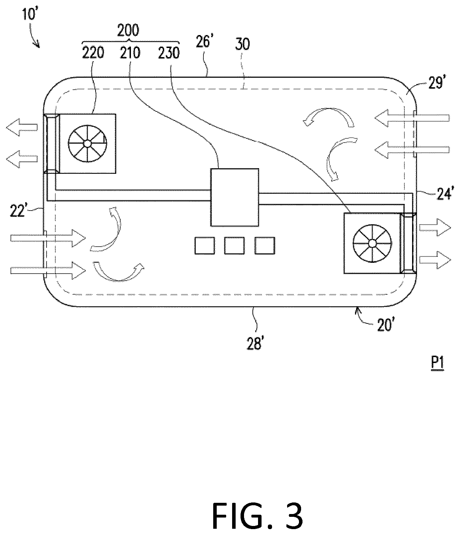

In the present embodiment, the first fan 120 and the second fan 130 are disposed on the longer side surfaces of the electronic device 10. However, the positions of the first fan 120 and the second fan 130 relative to the housing 20 are not limited therein. FIG. 3 is a schematic diagram showing a heat dissipating system using fans according to another embodiment of the invention. Referring to FIG. 3, in the present embodiment, for the front surface 29'of the housing 20' of the electronic device 10', the sides adjacent to the first side surface 22' and the second side surface 24' are short sides, and the sides adjacent to the third side surface 26' and the fourth side surface 28' are long sides. Under such configuration, when the user places the electronic device 10' under the horizontal state PI for operation, if the user uses the left hand to grips the first surface 22' of the housing 20' and the temperature signal is less than the predetermined value, the processor activates the second fan 230 close to the dominant hand to prevent the heated air from blowing toward the left hand of the user gripping the electronic device 20'. Similarly, if the user uses the left hand to grips the second side surface 24' of the housing 20', the processor 210 activates the first fan 220 close to the dominant hand. That is, in the present embodiment, under the situation that the first fan 220 and the second fan 230 are disposed at the short sides, when the electronic device 10' is placed under the horizontal state PI and the temperature signal is less than the predetermined value, the processor 210 would selectively activate one of the first fan 220 and the second fan 230 according to the handedness information.

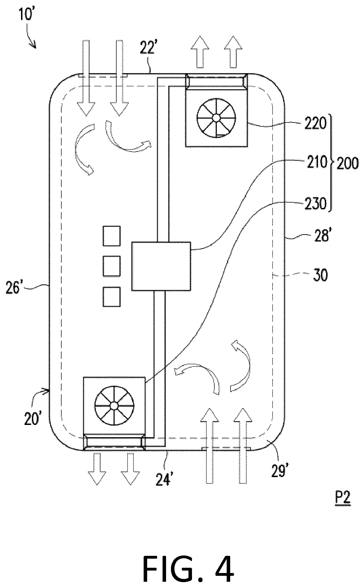

FIG. 4 is a schematic diagram showing the electronic device under the vertical state. Referring to FIG. 4, when the user places the electronic device 10' under the vertical state P2 for operation, if the user uses the left hand to grips the third side surface 26' of the housing 20', the first side surface 22' would be at the top and the second side surface 24' would be at the bottom. When the temperature signal is less than the predetermined value, the processor 210 activates the first fan 220 at the top. Similarly, if the user uses the left hand to grip the fourth side surface 28' of the housing 20', the first side surface 22' would be at the bottom and the second side surface 24' would be at the top. When the temperature signal is less than the predetermined value, the processor 210 activates the second fan 230 at the top. That is, in the present embodiment, under the situation that the first fan 220 and the second fan 230 are disposed at the short sides, when the electronic device 10' is under the vertical state P2 and the temperature signal is less than the predetermined value, the processor 210 activates the first fan 220 or the second fan 230 at the top. With this design, the heat dissipating system using fans 200 of the present embodiment can solve the issue that the user is affected by the heated airflow when gripping a specific side surface of the housing 20'.

To sum up, the heat dissipating system using fans of the embodiment of the invention has a dual-fan design. When the computation amount of the electronic device does not exceed a specific amount, i.e., when the temperature of the electronic device is lower than a predetermined value, the processor can selectively activate the first fan or the second fan according to the handedness information and the orientation signal, wherein the handedness information is received from the user interface circuit module input by the user, and the orientation signal is generated by the orientation sensor after sensing whether the electronic device is under the horizontal state or the vertical state. This can solve the problem that the heated airflow blows toward the user and enhances the comfort of the user when using the electronic device. Moreover, when the computation amount of the electronic device exceeds the specific amount, i.e., when the temperature of the electronic device is equal to or higher than the predetermined value, the first fan and the second fan can operate simultaneously to remove heat from the electronic device quickly.

## Claims

1. A heat dissipating system using fans (100) for use in an electronic device (10), the electronic device (10) including a housing (20), the housing (20) including a first side surface (22) and a second side surface (24) opposite to each other, the first side surface (22) and the second side surface (24) having a first air outlet (22a) and a second air outlet (24a), respectively, the heat dissipating system using fans (100) comprising:
a first fan (120) disposed in the housing (20) at a position corresponding to
the position of the first air outlet (22a);
a second fan (130) disposed in the housing (20) at a position corresponding
to the position of the second air outlet (24a);
an orientation sensor (150) disposed in the housing (20) for sensing whether the electronic device (10) is under a vertical state (P2) or a horizontal state (P1) and generating a corresponding orientation signal;
a temperature sensor (160) disposed in the housing (20) for sensing the temperature of the electronic device (10) and generating a temperature signal;
a user interface circuit module (140) comprising a memory and disposed in the housing (20) for receiving handedness information input by a user, wherein the handedness information is stored in the memory; and
a processor (110) disposed in the housing (20) and electrically connected with the first fan (120), the second fan (130), the orientation sensor (150), the temperature sensor (160) and the user interface circuit module (140), wherein when the temperature signal is greater than or equal to a predetermined value, the processor (110) is adapted to activate the first fan (120) and the second fan (130), and when the temperature signal is less than the predetermined value, the processor (110) is adapted to selectively activate one of the first fan (120) and the second fan (130) according to the handedness information transmitted by the user interface circuit module (140) and the orientation signal.

2. The heat dissipating system using fans according to claim 1, wherein the housing (20) further comprises a front surface (29) connecting the first side surface (22) and the second side surface (24), the electronic device (10) comprises a touch panel (30) disposed at the front surface (29), the front surface (29) is rectangular, the side connecting the front surface (29) and the first side surface (22) is a long side, and when the electronic device (10) is under the vertical state (P2) and the temperature signal is less than the predetermined value, the processor (110) is adapted to activate one of the first fan (120) and the second fan (130) according to the handedness information.

3. The heat dissipating system using fans according to claim 2, wherein when the electronic device (10) is under the horizontal state (P1) and the temperature signal is less than the predetermined value, the processor (110) is adapted to activate the first fan (120) or the second fan (130) at the top.

4. The heat dissipating system using fans according to claim 1, wherein the housing (20') further comprises a front surface (29') connecting the first side surface (22') and the second side surface (24'), the electronic device (10') comprises a touch panel (30) disposed at the front surface (29'), the front surface (29') is rectangular, the side connecting the front surface (29') and the first side surface (22') is a short side, and when the electronic device (10') is under the vertical state (P2) and the temperature signal is less than the predetermined value, the processor (210) is adapted to activate the first fan (220) or the second fan (230) at the top.

5. The heat dissipating system using fans according to claim 4, wherein when the electronic device (10') is under the horizontal state (P1) and the temperature signal is less than the predetermined value, the processor (210) is adapted to selectively activate one of the first fan (220) and the second fan (230) according to the handedness information.

6. The heat dissipating system using fans according to claim 1, wherein the second side surface (24) and the first side surface (22) have a first air inlet (24b) and a second air inlet (22b), respectively, the position of the second air inlet (22b) on the first side surface (22) corresponds to the position of the second air outlet (24a), and the position of the first air inlet (24b) on the second side surface (24) corresponds to the position of the first air outlet (22a).

7. The heat dissipating system using fans according to claim 1, wherein the processor (110) is a central processing unit of the electronic device.

8. The heat dissipating system using fans according to claim 7, further comprising:
two heat pipes (170) disposed in the housing (20) and extending from the processor (110) to the first air outlet (22a) and the second air outlet (24a), respectively.

9. The heat dissipating system using fans according to claim 1, wherein the processor (110) is adapted to store default handedness information in a built-in memory.

## Patentansprüche

1. Lüfterbasiertes Wärmeabgabesystem (100) in einem elektronischen Gerät (10), wobei das elektronische Gerät (10) ein Gehäuse (20) umfasst,
wobei das Gehäuse (20) eine erste Seitenfläche (22) und eine gegenüberliegende zweite Seitenfläche (24) aufweist,
wobei die erste Seitenfläche (22) einen ersten Luftauslass (22a) und die zweite Seitenfläche (24) einen zweiten Luftauslass (24a) aufweist, wobei das lüfterbasierte Wärmeabgabesystem (100) umfasst:
einen ersten Lüfter (120), der im Gehäuse (20) in einer der Position des ersten Luftauslasses (22a) entsprechenden Position angeordnet ist;
einen zweiten Lüfter (130), der im Gehäuse (20) in einer der Position des zweiten Luftauslasses (24a) entsprechenden Position angeordnet ist;
einen im Gehäuse (20) angeordneten Orientierungssensor (150), der erfassen soll, ob sich das elektronische Gerät (10) in einer vertikalen Lage (P2) oder einer horizontalen Lage (P1) befindet und ein entsprechendes Ausrichtungssignal erzeugen soll;
einen im Gehäuse (20) angeordneten Temperatursensor (160), der die Temperatur des elektronischen Gerätes (10) erfassen und ein entsprechendes Temperatursignal erzeugen soll;
ein im Gehäuse (20) angeordnetes Benutzerschnittstellen-Schaltmodul (140) mit Speicher, um die von einem Benutzer eingegebenen Informationen über Links-Rechts-Eigenschaften zu empfangen,
wobei die Informationen über Links-Rechts-Eigenschaften im Speicher gespeichert werden; und
ein im Gehäuse (20) angeordneter Prozessor (110), der mit dem ersten Lüfter (120), dem zweiten Lüfter (130), dem Orientierungssensor (150), dem Temperatursensor (160) und dem Benutzerschnittstellen-Schaltungsmodul (140) elektrisch verbunden ist,
wobei der Prozessor (110) dafür ausgelegt ist, den ersten Lüfter (120) und den zweiten Lüfter (130) zu aktivieren, wenn das Temperatursignal größer oder gleich einem vorbestimmten Wert ist und der Prozessor (110) dafür ausgelegt ist, entweder den ersten Lüfter (120) oder den zweiten Lüfter (130) entsprechend den über das Benutzerschnittstellen-Schaltmodul (140) übertragenen Informationen über Links-Rechts-Eigenschaften und dem Orientierungssignal zu aktivieren, wenn das Temperatursignal kleiner als ein vorbestimmter Wert ist.

2. Lüfterbasiertes Wärmeabgabesystem gemäß Anspruch 1,
wobei das Gehäuse (20) ferner eine die erste Seitenfläche (22) und die zweite Seitenfläche (24) verbindende Vorderfläche (29) umfasst und wobei das elektronische Gerät (10) ein an der Vorderfläche (29) angeordnetes Touch-Panel (30) umfasst, wobei die Vorderfläche (29) rechteckig ist, wobei die die Vorderfläche (29) und die erste Seitenfläche (22) verbindende Seite eine lange Seite ist und der Prozessor (110) dafür ausgelegt ist, den ersten Lüfter (120) oder den zweiten Lüfter (130) entsprechend den Informationen über Links-Rechts-Eigenschaften zu aktivieren, wenn sich das elektronische Gerät (10) in einer vertikalen Lage (P2) befindet und das Temperatursignal kleiner als ein vorbestimmter Wert ist.

3. Lüfterbasiertes Wärmeabgabesystem gemäß Anspruch 2,
wobei der Prozessor (110) dafür ausgelegt ist, den ersten Lüfter (120) oder den zweiten oberen Lüfter (130) zu aktivieren, wenn sich das elektronische Gerät (10) in der horizontalen Lage befindet und das Temperatursignal kleiner als ein vorbestimmter Wert ist.

4. Lüfterbasiertes Wärmeabgabesystem gemäß Anspruch 1,
wobei das Gehäuse (20) ferner eine die erste Seitenfläche (22) und die zweite Seitenfläche (24) verbindende Vorderfläche (29) umfasst und wobei das elektronische Gerät (10) ein an der Vorderfläche (29) angeordnetes Touch-Panel (30) umfasst, wobei die Vorderfläche (29) rechteckig ist, wobei die die Vorderfläche (29) und die erste Seitenfläche (22) verbindende Seite eine kurze Seite ist und der Prozessor (210) dafür ausgelegt ist, den ersten Lüfter (220) oder den zweiten oberen Lüfter (230) zu aktivieren, wenn sich das elektronische Gerät (10) in einer vertikalen Lage (P2) befindet und das Temperatursignal kleiner als ein vorbestimmter Wert ist.

5. Lüfterbasiertes Wärmeabgabesystem gemäß Anspruch 4,
wobei der Prozessor (210) dafür ausgelegt ist, den ersten Lüfter (220) oder den zweiten oberen Lüfter (230) entsprechend den Informationen über Links-Rechts-Eigenschaften zu aktivieren, wenn sich das elektronische Gerät (10) in der horizontalen Lage (P1) befindet und das Temperatursignal kleiner als ein vorbestimmter Wert ist.

6. Lüfterbasiertes Wärmeabgabesystem gemäß Anspruch 1,
wobei die zweite Seitenfläche (24) einen ersten Lufteinlass (24b) und die erste Seitenfläche (22) einen zweiten Lufteinlass (22b) aufweisen, wobei die Position des zweiten Lufteinlasses (22b) auf der ersten Seitenfläche (22) der Position des zweiten Luftauslasses (24a) entspricht und die Position des ersten Lufteinlasses (24b) auf der zweiten Seitenfläche (24) der Position des ersten Luftauslasses (22a) entspricht.

7. Lüfterbasiertes Wärmeabgabesystem gemäß Anspruch 1,
wobei der Prozessor (110) eine zentrale Verarbeitungseinheit des elektronischen Gerätes ist.

8. Lüfterbasiertes Wärmeabgabesystem gemäß Anspruch 7, ferner umfassend:
zwei im Gehäuse (20) angeordnete Wärmerohre (170), die sich vom Prozessor (110) zum ersten Luftauslass (22a) bzw. zum zweiten Luftauslass (24a) erstrecken.

9. Lüfterbasiertes Wärmeabgabesystem gemäß Anspruch 1, wobei der Prozessor (110) dafür ausgelegt ist, Informationen über Links-Rechts-Eigenschaften in einem eingebauten Speicher zu speichern.

## Revendications

1. Un système de dissipation de chaleur utilisant des ventilateurs (100) destiné à être utilisé dans un dispositif électronique (10), le dispositif électronique (10) comprenant un boîtier (20), le boîtier (20) comprenant une première surface latérale (22) et une seconde surface latérale (24) opposées, la première surface latérale (22) et la seconde surface latérale (24) ayant respectivement une première sortie d'air (22a) et une seconde sortie d'air (24a), le système de dissipation de chaleur utilisant les ventilateurs (100) comprenant :
un premier ventilateur (120) disposé dans le boîtier (20) en une position correspondant à la position de la première sortie d'air (22a) ;
un deuxième ventilateur (130) disposé dans le boîtier (20) en une position correspondant à la position de la seconde sortie d'air (24a) ;
un capteur d'orientation (150) disposé dans le boîtier (20) pour détecter si le dispositif électronique (10) est en position verticale (P2) ou en position horizontale (P1) et générer un signal d'orientation correspondant ;
un capteur de température (160) disposé dans le boîtier (20) pour détecter la température du dispositif électronique (10) et générer un signal de température ;
un module de circuit d'interface utilisateur (140) comprenant une mémoire et disposé dans le boîtier (20) pour recevoir des informations sur la manualité saisies par un utilisateur, dans lequel les informations sur la manualité sont stockées dans la mémoire ; et
un processeur (110) disposé dans le boîtier (20) et connecté électriquement avec le premier ventilateur (120), le second ventilateur (130), le capteur d'orientation (150), le capteur de température (160) et le module de circuit d'interface utilisateur (140), dans lequel lorsque le signal de température est supérieur ou égal à une valeur prédéterminée, le processeur (110) est adapté pour activer le premier ventilateur (120) et le second ventilateur (130), et lorsque le signal de température est inférieur à la valeur prédéterminée, le processeur (110) est adapté pour activer sélectivement l'un du premier ventilateur (120) et du second ventilateur (130) en fonction des informations sur la manualité transmises par le module de circuit interface utilisateur (140) et le signal d'orientation.

2. Le système de dissipation de chaleur utilisant des ventilateurs selon la revendication 1, dans lequel le boîtier (20) comprend en outre une surface avant (29) reliant la première surface latérale (22) et la seconde surface latérale (24), le dispositif électronique (10) comprend un panneau tactile (30) disposé sur la surface avant (29), la surface avant (29) est rectangulaire, le côté reliant la surface avant (29) et la première surface latérale (22) est un côté long, et lorsque le dispositif électronique (10) est en position verticale (P2) et que le signal de température est inférieur à la valeur prédéterminée, le processeur (110) est adapté pour activer un du premier ventilateur (120) et du second ventilateur (130) en fonction des informations sur la manualité.

3. Le système de dissipation de chaleur utilisant des ventilateurs selon la revendication 2, dans lequel, lorsque le dispositif électronique (10) est en position horizontale (P1) et le signal de température est inférieur à la valeur prédéterminée, le processeur (110) est adapté pour activer le premier ventilateur (120) ou le second ventilateur (130) en haut.

4. Le système de dissipation de chaleur utilisant des ventilateurs selon la revendication 1, dans lequel le boîtier (20') comprend en outre une surface avant (29') reliant la première surface latérale (22') et la seconde surface latérale (24'), le dispositif électronique (10') comprend un panneau tactile (30) disposé sur la surface avant (29'), la surface avant (29') est rectangulaire, le côté reliant la surface avant (29') et la première surface latérale (22') est un côté court, et lorsque le dispositif électronique (10') est en position verticale (P2) et que le signal de température est inférieur à la valeur prédéterminée, le processeur (210) est adapté pour activer le premier ventilateur (220) ou le second ventilateur (230) en haut.

5. Le système de dissipation de chaleur utilisant des ventilateurs selon la revendication 4, dans lequel, lorsque le dispositif électronique (10') est en position horizontale (P1) et que le signal de température est inférieur à la valeur prédéterminée, le processeur (210) est adapté pour activer sélectivement l'un du premier ventilateur (220) et du second ventilateur (230) en fonction des informations sur la manualité.

6. Le système de dissipation de chaleur utilisant des ventilateurs selon la revendication 1, dans lequel la seconde surface latérale (24) et la première surface latérale (22) ont respectivement une première entrée d'air (24b) et une seconde entrée d'air (22b), la position de la seconde entrée d'air (22b) sur la première surface latérale (22) correspond à la position de la seconde sortie d'air (24a), et la position de la première entrée d'air (24b) sur la seconde surface latérale (24) correspond à la position de la première sortie d'air (22a).

7. Le système de dissipation de chaleur utilisant des ventilateurs selon la revendication 1, dans lequel le processeur (110) est une unité centrale de traitement du dispositif électronique.

8. Le système de dissipation de chaleur utilisant des ventilateurs selon la revendication 7, comprenant en outre :
deux caloducs (170) disposés dans le boîtier (20) et s'étendant respectivement du processeur (110) vers la première sortie d'air (22a) et la seconde sortie d'air (24a).

9. Le système de dissipation de chaleur utilisant des ventilateurs selon la revendication 1, dans lequel le processeur (110) est adapté pour stocker des informations sur la manualité par défaut dans une mémoire intégrée.
